# EUROPÄISCHE PATENTSCHRIFT

(11) **EP 3 688 848 B1**
(45) Veröffentlichungstag und Bekanntmachung des Hinweises auf die Patenterteilung: **03.01.2024**
(21) Anmeldenummer: 18772749.0
(22) Anmeldetag: 05.09.2018
(51) Int. Cl.: H01S 5/024

(54) **KÜHLVORRICHTUNG ZUM KÜHLEN EINES ELEKTRISCHEN BAUTEILS UND VERFAHREN ZUR HERSTELLUNG EINER KÜHLVORRICHTUNG**
COOLING DEVICE FOR COOLING AN ELECTRICAL COMPONENT AND METHOD FOR PRODUCING A COOLING DEVICE
DISPOSITIF DE REFROIDISSEMENT POUR REFROIDIR UN COMPOSANT ÉLECTRIQUE ET PROCÉDÉ DE FABRICATION D'UN DISPOSITIF DE REFROIDISSEMENT

(30) Priorität: 28.09.2017 DE 102017122575
(43) Veröffentlichungstag der Anmeldung: 05.08.2020
(73) Patentinhaber: Rogers Germany GmbH, 92676 Eschenbach (DE)
(72) Erfinder: BRITTING, Stefan, 91220 Schnaittach (DE); KUHN, Nico, 92676 Eschenbach (DE); GÖTZ, Manfred, 92637 Weiden (DE); MEYER, Andreas, 93173 Wenzenbach (DE); GIL, Vitalij, 91217 Hersbruck (DE); WIESEND, Johannes, 92676 Speinshart (DE)
(74) Vertreter: Müller Schupfner & Partner Patent- und Rechtsanwaltspartnerschaft mbB
(86) Internationale Anmeldenummer: PCT/EP2018/073836
(87) Internationale Veröffentlichungsnummer: WO 2019/063251

(56) Entgegenhaltungen:
- CN-U- 202 652 683
- DE-U1- 20 302 430
- US-A1- 2006 203 866

## Beschreibung

Die vorliegende Erfindung betrifft eine Kühlvorrichtung zum Kühlen eines elektrischen bzw. elektronischen Bauteils, insbesondere einer Laserdiode, und ein Verfahren zur Herstellung einer Kühlvorrichtung.

Solche Kühlvorrichtungen sind beispielsweise aus der JP 2016 115 767 A bekannt und sollen primär einer Hitzeentwicklung des elektrischen Bauteils im Betrieb entgegenwirken. Wesentlicher Bestandteil solcher Kühlvorrichtungen ist ein Grundkörper, in den ein oder mehrere Kühlkanäle integriert sind und an dessen Außenseite an einer Anbindungs- bzw. Montagefläche das elektrische Bauteil, z. B. eine Laserdiode, anbringbar ist. Da die Laserdiode und der Grundkörper typischerweise aus unterschiedlichen Materialien gefertigt sind, weisen sie in entsprechender Weise verschiedene thermische Ausdehnungskoeffizienten auf. Die Folge ist, dass im Grenzbereich zwischen Laserdiode und Grundkörper mechanische Spannungen entstehen können, die zu einer Verformung der Laserdiode führen oder dass sich der Grundkörper verformt, so dass sich auch die Laseriode verformt. Infolge dieser Verformung kommt es zum sogenannten "Smile"-Effekt, bei dem die nebeneinander angeordneten Einzelemitter eines Laserdiodenbarrens höhenversetzt zueinander ihr Licht aussenden. Folge dieses "Smile"-Effekts ist ein erhöhter Aufwand beim Fokussieren des von den Einzelemittern ausgesendeten Lichts.

Um für eine gewünschte Geradlinigkeit der Einzelemitter in einem Laserdiodenbarren zu sorgen, kennt der Stand der Technik Stabilisierungsschichten bzw. Zwischenschichten zwischen Bauteil und Grundkörper, sogenannte Submounts, die zum Angleichen der Ausdehnungskoeffizienten an der Außenseite des Grundkörpers befestigt werden und als Sockel die Laserdiode tragen. Wie aus der JP 2016 115 767 A ersichtlich, ist es zudem üblich, dass neben der Stabilisierungsschicht an der Anbindungsfläche eine weitere Stabilisierungsschicht am Grundkörper vorgesehen ist, die auf der der Anbindungsfläche gegenüberliegenden Seite des Grundkörpers angeordnet ist. Diese Lösung führt allerdings dazu, dass Laserdiodenhersteller in aufwendiger Weise zunächst einmal die Stabilisierungsschichten realisieren müssen, um in einem weiteren Arbeitsschritt dann die Laserdiode am Kühlkörper zu befestigen.

Die CN 202 652 683 zeigt eine Kühlvorrichtung zum Kühlen eines elektrischen Bauteils mit einem Grundkörper mit einer Außenseite und mindestens einem integrierten Kühlkanal. Eine Anbindung erfolgt hier über eine Anbindungsfläche an der Außenseite des Grundkörpers. Aus der DE 203 02 430 U1 ist eine Halbleitervorrichtung bekannt, bei der ein Halbleiterelement über einen Zwischenträger an einem Kühlelement mit einem Kühlkanal angebunden ist.

Es ist somit eine Aufgabe der vorliegenden Erfindung, eine Kühlvorrichtung bereitzustellen, auf die sich die Laserdiode auf einfache Weise montieren lässt, wobei zudem dem "Smile" - Effekt entgegengewirkt werden soll.

Diese Aufgabe wird gelöst durch eine Kühlvorrichtung gemäß Anspruch 1 und ein Verfahren gemäß Anspruch 14. Weitere Vorteile und Merkmale der Erfindung ergeben sich aus den Unteransprüchen sowie der Beschreibung und den beigefügten Figuren.

Erfindungsgemäß ist eine Kühlvorrichtung zum Kühlen eines elektrischen Bauteils, insbesondere einer Laserdiode, vorgesehen, umfassend:
- ein Grundkörper mit mindestens einer Außenseite und mindestens einem integrierten Kühlkanal, insbesondere Mikrokühlkanal,
- eine Anbindungsfläche an der Außenseite des Grundkörpers zur Anbindung des elektrischen Bauteils an den Grundkörper und
- eine erste Stabilisierungsschicht,
wobei die erste Stabilisierungsschicht und die Anbindungsfläche entlang einer Primärrichtung zumindest teilweise übereinander angeordnet sind, und wobei die erste Stabilisierungsschicht gegenüber der Außenseite ins Innere des Grundkörpers um einen Abstand entlang einer parallel zur Primärrichtung verlaufenden Richtung versetzt bzw. hineinversetzt ist.

Gegenüber dem Stand der Technik hat sich in überraschender Weise herausgestellt, dass eine Anpassung der thermischen Ausdehnungskoeffizienten auch dann noch in einem ausreichenden Umfang erfolgen kann, wenn die erste Stabilisierungsschicht gegenüber der Anbindungsfläche erfindungsgemäß nach innen versetzt ist und nicht Teil der Außenseite des Grundkörper ist. Die Folge ist, dass eine Kühlvorrichtung bereitgestellt werden kann, in die bereits eine erste Stabilisierungsschicht integriert ist, so dass auf der Seite der Bauteilhersteller direkt eine unmittelbare Anbindung des elektrischen Bauteils, insbesondere der Laserdiode, erfolgen kann. Ein weiterer Vorteil besteht darin, dass die Integration der ersten Stabilisierungsschicht diese gegen Umwelteinflüsse schützt, z. B. vor Korrosionsschädigungen. Insbesondere ist es vorgesehen, dass das Bauteil ein Laserdiodenbarren mit mehreren Einzelemittern umfasst.

Vorzugsweise ist es dabei vorgesehen, dass sich die Primärrichtung im Wesentlichen senkrecht zur Anbindungsfläche bzw. einer Außenseite des Grundkörpers erstreckt. Beispielsweise ist die Anbindungsfläche ein Teil einer sich entlang der Längserstreckung des Grundkörpers erstreckenden Außenseite. Insbesondere bildet die Anbindungsfläche weniger als ein Viertel dieser Außenseite. Ferner weist der Grundkörper einen Ein- und Ausgang auf, über die ein Kühlfluid in den Kühlkanal eingeleitet werden kann. Unter einem integrierten Kühlkanal ist vorzugsweise ein solcher Kühlkanal zu verstehen, der im Wesentlichen, d. h. insbesondere mit Ausnahme des Eingangs und Ausgangs, im Inneren des Grundkörpers verläuft. Insbesondere ist der Grundkörper aus einem Metall, vorzugsweise Kupfer, gefertigt, während die erste Stabilisierungsschicht aus einem anderen Material, insbesondere einem Nichtmetall, gefertigt ist. Ferner erstreckt sich die erste Stabilisierungsschicht im Wesentlichen parallel zur Anbindungsfläche. Es ist aber auch vorstellbar, dass die erste Stabilisierungsschicht schräg zur Außenseite verläuft.

Gemäß einer weiteren Ausführungsform der vorliegenden Erfindung ist es vorgesehen, dass eine zweite Stabilisierungsschicht vorgesehen ist, wobei die erste Stabilisierungsschicht, die zweite Stabilisierungsschicht und die Anbindungsfläche entlang einer Primärrichtung zumindest teilweise übereinander angeordnet sind und die erste Stabilisierungsschicht näher an der Anbindungsfläche als die zweite Stabilisierungsschicht angeordnet ist. Mittels einer zweiten Stabilisierungsschicht lässt sich mit Vorteil einer Krümmung des Grundkörpers bei thermischer Beanspruchung und damit der Ausbildung eines "Smile"-Effekts entgegenwirken, wenn Einzelemitter eines Laserbarrens auf der Kühlvorrichtung angeordnet sind. Hierbei ist es vorzugsweise vorgesehen, dass die zweite Stabilisierungsschicht parallel zur Anbindungsfläche und/oder der ersten Stabilisierungsschicht verläuft. Es ist aber auch vorstellbar, dass die erste Stabilisierungsschicht und/oder zweite Stabilisierungsschicht schräg zur Außenseite verlaufen. Vorzugsweise ist die zweite Stabilisierungsschicht ebenfalls in den Grundkörper integriert. Insbesondere ist die zweite Stabilisierungsschicht gegenüber einer der Anbindungsfläche am Grundkörper gegenüberliegenden weiteren Außenseite um einen weiteren Abstand ins Innere des Grundkörpers versetzt.

Insbesondere ist es vorgesehen, dass die erste Stabilisierungsschicht und die zweite Stabilisierungsschicht in Hinblick auf ihre Materialzusammensetzung und ihre geometrische Form einander entsprechen. Vorzugsweise entspricht dann der Abstand, d. h. eine Distanz zwischen der ersten Stabilisierungsschicht und der Außenseite, dem weiteren Abstand, d. h. einer Distanz zwischen der zweiten Stabilisierungsschicht und der weiteren Außenseite.

Zweckmäßig ist es vorgesehen, dass der Abstand zwischen der Anbindungsfläche und der ersten Stabilisierungsschicht einen Wert zwischen 100 µm und 1000 µm, bevorzugt zwischen 150 µm und 750 µm und besonders bevorzugt zwischen 200 µm und 500 µm annimmt. Insbesondere hat sich für Abstandswerte zwischen 300 µm und 500 µm herausgestellt, dass eine in der Fertigung ausreichend stabiler Teil des Grundkörpers herstellen lässt und zudem ein möglichst großer Einfluss auf den Ausdehnungskoeffizienten im Bindungsbereich zwischen dem Bauteil und dem Grundkörper genommen werden kann.

In einer weiteren Ausführungsform der vorliegenden Erfindung ist es vorgesehen, dass die erste Stabilisierungsschicht Diamant und/oder Siliziumkarbid umfasst. Denkbar sind auch andere Materialien mit hoher thermischer Leitfähigkeit wie z.B. AlN, BeO, W, Mo oder Si und/oder Komposite mit metallischer Matrix auf Basis von Cu oder Ag. Wegen der sehr hohen Wärmeleitfähigkeit erweist sich eine erste Stabilisierungsschicht aus Diamant und/oder Siliziumkarbid als besonders vorteilhaft für die Wärmespreizung beim Wärmetransport vom Wärme entwickelnden elektrischen Bauteil zum Kühlkanal bzw. in den Grundkörper. Weiterhin ist es vorstellbar, dass die erste Stabilisierungsschicht und/oder die zweite Stabilisierungsschicht in Primärrichtung und/oder Sekundärrichtung gesehen durchgehend oder unterbrochen ist. Ferner ist es denkbar, dass mehrere erste Stabilisierungsschichten und/oder mehrere zweite Stabilisierungsschichten in Primärrichtung gesehen übereinanderliegend angeordnet sind.

Vorzugsweise ist es vorgesehen, dass die erste Stabilisierungsschicht und die Anbindungsfläche in Primärrichtung gesehen deckungsgleich zueinander angeordnet sind. Unter "deckungsgleich" ist insbesondere zu verstehen, dass die erste Stabilisierungsschicht in einer senkrecht zur Primärrichtung verlaufenden Sekundärrichtung gesehen die Anbindungsfläche bzw. die Laserdiode nicht überragt bzw. bündig mit ihr abschließt. Vorzugsweise entsprechen die in einer senkrecht zur Primärrichtung bemessenen Ausdehnungen bzw. Flächen der Anbindungsfläche einerseits und der Sekundärschicht anderseits einander. Denkbar ist auch, dass die zweite Stabilisierungsschicht deckungsgleich zur Anbindungsfläche und/oder der ersten Stabilisierungsfläche angeordnet ist. Insbesondere ist es vorgesehen, dass sich die erste Stabilisierungsschicht und/oder die zweite Stabilisierungsschicht nicht über die gesamte Länge bzw. gesamte Längserstreckung der Kühlvorrichtung entlang der Sekundärrichtung erstreckt. Dadurch lassen sich mit Vorteil der Material- und der damit einhergehenden Kostenmehraufwand für die erste Stabilisierungsschicht und die zweite Stabilisierungsschicht reduzieren. Insbesondere verläuft die Sekundärrichtung parallel zur Längsrichtung bzw. -erstreckung des Grundkörpers.

Vorzugsweise ist es vorgesehen, dass zwischen der ersten Stabilisierungsschicht und der zweiten Stabilisierungsschicht in Primärrichtung gesehen mindestens ein Teilbereich des Kühlkanals verläuft. Dadurch lässt sich mit Vorteil das Kühlfluid möglichst nah an die zu kühlende Laserdiode heranführen. Beispielsweise ist ein Umlenkbereich des Kühlkanals in Primärrichtung gesehen unterhalb der Anbindungsfläche angeordnet. Vorzugsweise nimmt ein Verhältnis einer entlang der Sekundärrichtung bemessenen Länge desjenigen Teilbereich des Kühlkanals, der in Primärrichtung gesehen zwischen der ersten Stabilisierungsschicht und der zweiten Stabilisierungsschicht angeordnet ist, zur entlang der Sekundärrichtung bemessenen Länge der ersten Stabilisierungsschicht einen Wert zwischen 0,2 und 0,8, bevorzugt zwischen 0,5 und 0,75 und besonders bevorzugt zwischen 0,6 und 0,7 an. Insbesondere bei einem Verhältnis zwischen 0,6 und 0,7 hat sich gezeigt, dass eine möglichst gleichmäßige Kühlung des Bauteils durch den Kühlkanal realisierbar ist.

Insbesondere ist es vorgesehen, dass sich die erste Stabilisierungsschicht entlang einer senkrecht zur Primärrichtung verlaufenden Sekundärrichtung über eine erste Länge erstreckt, wobei sich die zweite Stabilisierungsschicht entlang der Sekundärrichtung über eine zweite Länge erstreckt und die Anbindungsfläche sich entlang der Sekundärrichtung über eine dritte Länge erstreckt, wobei das Verhältnis der ersten Länge und/oder der zweiten Länge zur dritten Länge einen Wert zwischen 0,5 und 6,0 annimmt, vorzugsweise einen Wert zwischen 0,5 und 3,0, bevorzugt einen Wert zwischen 0,9 und 2,0 und besonders bevorzugt zwischen 0,95 und 1,5 annimmt. Dadurch erstreckt sich die erste Stabilisierungsschicht bzw. die zweite Stabilisierungsschicht in Sekundärrichtung gesehen weiter als die Anbindungsfläche. Insbesondere mit Diamant bzw. Siliziumkarbid als Materialien für die erste Stabilisierungsschicht und die zweite Stabilisierungsschicht lässt sich durch diese gegenüber der dritten Länge größer gewählte Länge eine weitere Wärmeaufspreizung im Grundkörper realisieren. Vorzugweise ist es vorgesehen, dass die erste Länge und/oder die zweite Länge einen Wert zwischen 5 und 25 mm bevorzugt zwischen 6 und 18 mm und besonders bevorzugt zwischen 7 und 15 mm annimmt. Vorzugsweise nimmt ein Verhältnis zwischen der entlang der Sekundärrichtung S bemessenen dritten Länge der Anbindungsfläche zu der ersten Länge der ersten Stabilisierungsschicht einen Wert zwischen 0,33 und 0,99, bevorzugt zwischen 0,5 und 0,98 und besonders bevorzugt zwischen 0,66 und 0,95 an.

Zweckmäßig ist es vorgesehen, dass sich die erste Stabilisierungsschicht von der zweiten Stabilisierungsschicht unterscheidet, insbesondere in Hinblick auf die Position innerhalb des Grundkörpers, ihre Materialzusammensetzung und/oder ihre Ausdehnung , insbesondere Dicke, in einer parallel zur Primärrichtung verlaufenden Richtung. Dadurch ist es beispielsweise möglich, in die erste Stabilisierungsschicht Diamant und/oder Siliziumkarbid zu integrieren, während die zweite Stabilisierungsschicht Molybdän, Wolfram, Silizium, ein Laminat, CuW, CuMo oder eine Keramik bzw. ein Glas aufweist. Dadurch lassen sich Zusatzkosten für die zweite Stabilisierungsschicht steuern bzw. gering halten. Um dennoch in Primärrichtung gesehen eine Symmetrisierung des thermischen Ausdehnungskoeffizienten zu realisieren und so einem Durchbiegen des Grundkörpers entgegenzuwirken, ist es mit Vorteil vorgesehen, dass die zweite Stabilisierungsschicht entsprechend, d. h. in Hinblick auf Dimensionierung und Position der zweiten Stabilisierungsschicht, modifiziert wird.

Vorzugsweise ist es vorgesehen, dass die erste Länge und/oder die dritte Länge größer ist als ein in Primärrichtung bemessener Abstand zwischen der ersten Stabilisierungsschicht und der Anbindungsfläche.

Ein weiterer Aspekt der vorliegenden Erfindung ist ein Verfahren zur Herstellung einer Kühlvorrichtung gemäß einem der vorhergehenden Ansprüche, wobei die erste und/oder die zweite Stabilisierungsschicht mittels eines Aktivlot-Verfahrens an den Grundkörper angebunden werden. Alle für die erfindungsgemäße Kühlvorrichtung beschriebenen Merkmale und deren Vorteile lassen sich sinngemäß ebenfalls auf das erfindungsgemäße Verfahren übertragen und andersherum.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca.650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Mittels des Aktivlotverfahrens ist es mit Vorteil möglich Diamant und/oder Siliziumkarbonat an den Grundkörper anzubinden.

Es zeigt:
- **Fig.1:**: eine Kühlvorrichtung gemäß einer ersten bevorzugten Ausführungsform der vorliegenden Erfindung
- **Fig. 2:**: eine Kühlvorrichtung gemäß einer zweiten bevorzugten Ausführungsform der vorliegenden Erfindung und
- **Fig.3**: eine Kühlvorrichtung gemäß einer dritten bevorzugten Ausführungsform der vorliegenden Erfindung

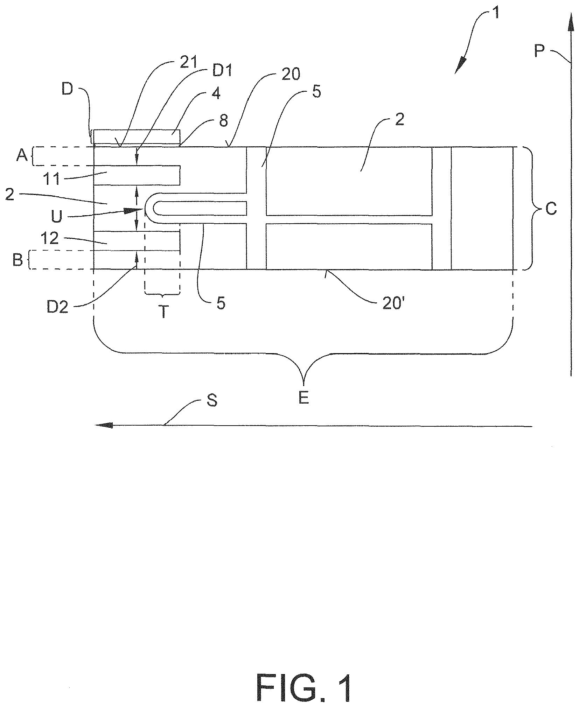

In der **Figur 1** ist eine Kühlvorrichtung 1 gemäß einer ersten beispielhaften Ausführungsform der vorliegenden Erfindung dargestellt. Insbesondere handelt es sich bei der Kühlvorrichtung 1 um eine solche, die zum Kühlen von elektrischen Bauteilen 4, wie z. B. Laserdioden, vorgesehen sind, um einem Überhitzen der Laserdioden 4 im Betrieb entgegenzuwirken. Wesentliche Bestandteile der Kühlvorrichtung 1 ist ein Grundkörper 2, in dem Kühlkanäle 5, insbesondere Mikrokühlkanäle, verlaufen. Dabei ist der Grundkörper 2 vorzugsweise aus einem Metall, beispielsweise Kupfer, gefertigt. Ferner ist am Grundkörper 2 ein Eingang und ein Ausgang vorgesehen, über den ein Fluid, insbesondere eine Kühlflüssigkeit, im Betrieb ein- und ausgeleitet werden kann.

Ferner umfasst eine Außenseite 20 einen Anbindungsbereich 21, an dem die Laserdiode 4 mit der Dicke D angebunden ist, beispielsweise mittels eines Lotmaterials 8. In dem dargestellten Ausführungsbeispiel verläuft der Kühlkanal 5 in einer Primärrichtung P gesehen zumindest teilweise unterhalb des Anbindungsbereichs 21 und der Anbindungsbereich 21 schließt vorzugsweise mit einer Kante des Grundkörpers 2 in einer senkrecht zur Primärrichtung P verlaufenden Sekundärrichtung S ab. Dabei verläuft die Primärrichtung P insbesondere senkrecht zu derjenigen Ebene, entlang der sich der Anbindungsbereich 21 bzw. die Außenseite 20 der Kühlvorrichtung 1 erstreckt. Vorzugsweise ist ein Umlenkbereich U des Kühlkanals 5 in Primärrichtung P gesehen unterhalb des Anbindungsbereichs 21 angeordnet. Dadurch lässt sich ein kühlendes Fluid im Kühlkanal 5 möglichst nah an den Anbindungsbereich 21 und somit an die Laserdiode 4 heranführen.

Wegen der unterschiedlichen thermischen Ausdehnungskoeffizienten im Grundkörper 2 einerseits und des elektrischen Bauteils 4 andererseits können mechanische Spannungen entstehen, die mitunter zu einer Verformung des Anbindungsbereichs 21 bzw. der Laserdiode 4 führen können. Da solche Geometrieänderungen unmittelbar den "Smile" -Effekt verursachen, ist es von Vorteil, diese mechanischen Spannungen zu unterdrücken. Hierzu sind vorzugsweise eine erste Stabilisierungsschicht 11 ggf. und eine zweite Stabilisierungsschicht 12 vorgesehen, mit denen eine Anpassung des Ausdehnungskoeffizienten des Grundkörpers 2 an den Ausdehnungskoeffizienten der Laserdiode 4 realisiert wird. Dabei ist es insbesondere vorgesehen dass in Primärrichtung P gesehen, die erste Stabilisierungsschicht 11, die zweite Stabilisierungsschicht 12 und der Anbindungsbereich 21 übereinanderliegen.

Um eine Kühlvorrichtung 1 bereitzustellen, bei der die Laserdiode 4 unmittelbar, d. h. ohne die Anbindung von Zwischenelementen an der Außenseite 20, angebunden werden kann, ist es vorgesehen, dass die erste Stabilisierungsschicht 11 gegenüber der Außenseite 20 bzw. dem Anbindungsbereich 21 um einen parallel zur Primärrichtung P bemessenen Abstand A ins Innere des Grundkörpers 2 versetzt ist. Mit anderen Worten: für die Anbindung der Laserdiode 4 ist es nicht erforderlich die erste Stabilisierungsschicht 11 und die zweite Stabilisierungsschicht 12 an der Außenseite 20 bzw. als Zwischenschicht zwischen den Grundkörper 2 und die Laserdiode 4 anzubinden, so dass der Fertigungsaufwand reduziert wird. Außerdem erlaubt die gegenüber der Außenseite 20 versetzte Anordnung, dass die Laserdiode 4 unmittelbar über den Grundkörper 2 elektrisch kontaktiert werden kann.

Vorzugsweise ist es vorgesehen, dass die erste Stabilisierungsschicht 11 und/oder die zweite Stabilisierungsschicht 12 Diamant oder Siliziumkarbid (SiC) umfassen oder daraus gefertigt sind. Dadurch lässt sich mit Vorteil eine möglichst große Wärmespreizung realisieren. Insbesondere sind in der Ausführungsform in Figur 1 die erste Stabilisierungsschicht 11 und die zweite Stabilisierungsschicht 12 aus demselben Material gefertigt. Um im Grundkörper 2 eine bevorzugt symmetrische Veränderungen des Ausdehnungskoeffizienten zu veranlassen, ist die zweite Stabilisierungsschicht 12 gegenüber einer der Außenseite 20 gegenüberliegenden weiteren Außenseite 20' um den weiteren Abstand B ins Innere des Grundkörper 2 hineinversetzt, wobei der Abstand A vorzugsweise dem weiteren Abstand B entspricht. Zudem entspricht eine in Primärrichtung P bemessene Schichtdicke D1 der ersten Stabilisierungsschicht 11 der Schichtdicke D2 der zweiten Stabilisierungsschicht 12. Mit anderen Worten: die erste Stabilisierungsschicht 11 und die zweite Stabilisierungsschicht 12 entsprechen einander in Form und vorzugsweise in der Materialzusammensetzung, sind aber auf gegenüberliegenden Seiten in den Grundkörper 2 integriert, wobei der Abstand A der ersten Stabilisierungsschicht 11 zur Außenseite 20 dem weiteren Abstand B der zweiten Stabilisierungsschicht 12 zur weiteren Außenseite 20' entspricht.

Um einen Materialaufwand für die erste Stabilisierungsschicht 11 und die zweite Stabilisierungsschicht 12 möglichst gering zu halten, ist es vorzugsweise vorgesehen, dass die erste Stabilisierungsschicht 11, die zweite Stabilisierungsschicht 12 und die Anbindungsfläche 21 in Primärrichtung P gesehen deckungsgleich zueinander angeordnet sind, d. h. die erste Stabilisierungsschicht 11 und die zweite Stabilisierungsschicht 12 erstrecken sich in einer senkrecht zur Primärrichtung P verlaufenden Ebene bzw. entlang der Sekundärrichtung S nur soweit wie es durch die Anbindungsfläche 21 vorgegeben ist. Insbesondere ist es vorgesehen, dass die erste Stabilisierungsschicht 11, die zweite Stabilisierungsschicht 12 und die Anbindungsfläche 21 entlang einer Sekundärrichtung S gesehen bündig mit dem Grundkörper 2 abschließen, d. h. die erste Stabilisierungsschicht 11, die zweite Stabilisierungsschicht 12 und die Anbindungsfläche 21 sind am Rand des Grundkörper angeordnet.

Weiterhin ist es vorgesehen, dass sich der Kühlkanal 5 zumindest teilweise zwischen der ersten Stabilisierungsschicht 11 und der zweiten Stabilisierungsschicht 12 erstreckt. Vorzugsweise nimmt ein Verhältnis einer entlang der Sekundärrichtung S bemessenen Länge desjenigen Teilabschnitts T des Kühlkanals 5, der in Primärrichtung P gesehen zwischen der ersten Stabilisierungsschicht 11 und der zweiten Stabilisierungsschicht 12 angeordnet ist, zur entlang der Sekundärrichtung S bemessenen Länge L1 der ersten Stabilisierungsschicht 11 einen Wert zwischen 0,2 und 0,8, bevorzugt zwischen 0,5 und 0,75 und besonders bevorzugt zwischen 0,6 und 0,7 an.

Zudem weist der Grundkörper 2 eine entlang der Primärrichtung P bemessene Höhe C auf, die mehr als doppelt, vorzugsweise mehr als vierfach und besonders bevorzugt mehr als 6-mal so groß ist wie die in dieselbe Richtung bemessene Dicke D der Laserdiode 4. Außerdem hat der Grundkörper 2 eine entlang der Sekundärrichtung S bemessene Längserstreckung E, die mehr als dreimal, mehr als fünfmal und besonders bevorzugt mehr als achtmal so groß ist wie die entlang der Sekundärrichtung S bemessene dritte Länge L3 der Laserdiode 4.

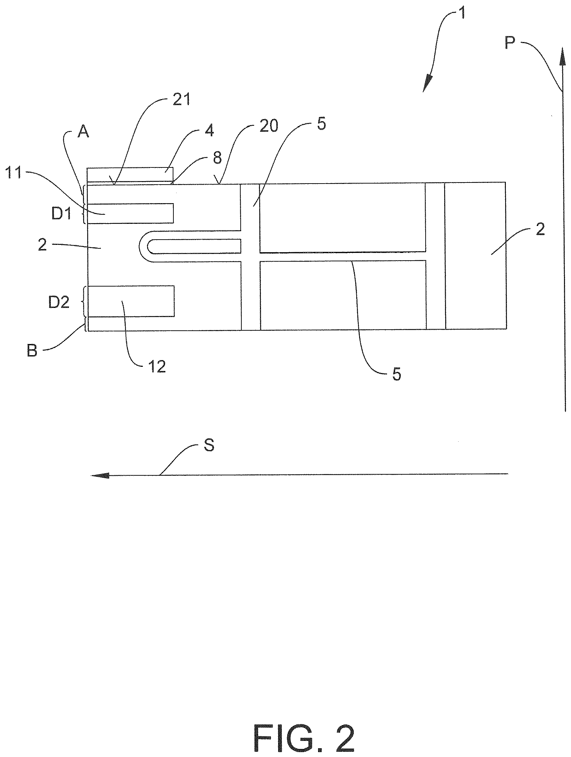

In **Figur 2** ist eine Kühlvorrichtung 1 gemäß einer zweiten bevorzugten Ausführungsform der vorliegenden Erfindung dargestellt. Dabei unterscheidet sich die dargestellte Ausführungsform von derjenigen aus Figur 1 im Wesentlichen nur dahingehend, dass sich die zweite Stabilisierungsschicht 12 von der ersten Stabilisierungsschicht 11 unterscheidet. Vorzugsweise umfasst die zweite Stabilisierungsschicht 12 statt Diamant oder Siliziumkarbonat (SiC) ein anderes Material, wie z. B. Molybdän oder Wolfram. Um dennoch für einen gegenüber der Primärrichtung P symmetrische Ausdehnungskoeffizienten zu sorgen, sind die Schichtdicke D2 der zweiten Stabilisierungsschicht 12 und vorzugsweise der weitere Abstand B zur weiteren Außenseite 20` entsprechend angepasst.

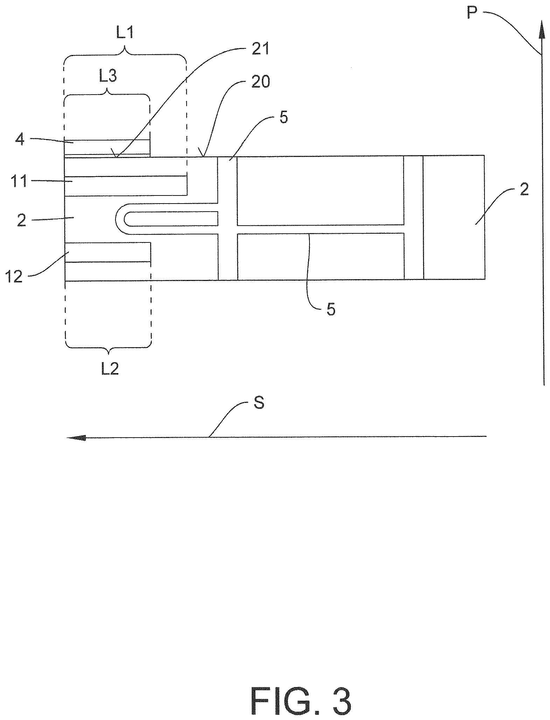

In **Figur 3** ist eine Kühlvorrichtung 1 gemäß einer zweiten bevorzugten Ausführungsform der vorliegenden Erfindung dargestellt. Dabei unterscheidet sich die dargestellte Ausführungsform von derjenigen aus Figur 1 im Wesentlichen nur dahingehend, dass sich die erste Stabilisierungsschicht 11 in Sekundärrichtung S weiter erstreckt als eine dritter Länge L3 der Laserdiode 4 bzw. der Anbindungsfläche 21. Vorzugsweise nimmt ein Verhältnis zwischen einer entlang der Sekundärrichtung S bemessenen dritten Länge L3 der Anbindungsfläche 21 zu der ersten Länge L1 der ersten Stabilisierungsschicht 11 einen Wert zwischen 0,33 und 0,99, bevorzugt zwischen 0,5 und 0,98 und besonders bevorzugt zwischen 0,66 und 0,95 an. Ferner erstreckt sich die zweite Stabilisierungsschicht 12 entlang der Sekundärrichtung S über eine zweite Länge L2 erstreckt.

### Bezugszeichenliste:

- 1: Kühlvorrichtung
- 2: Grundkörper
- 4: elektrisches Bauteil (z. B. Laseriode)
- 5: Kühlkanal
- 8: Lotmaterial
- 11: erste Stabilisierungsschicht
- 12: zweite Stabilisierungsschicht
- 20: Außenseite
- 20': weiteren Außenseite
- 21: Anbindungsfläche
- A: Abstand
- B: weiterer Abstand
- C: Höhe des Grundkörpers
- D: Schichtdicke der Laserdiode
- D1: Schichtdicke der ersten Stabilisierungsschicht
- D2: Schichtdicke der zweiten Stabilisierungsschicht
- L1: erste Länge
- L2: zweite Länge
- L3: dritte Länge
- E: Längserstreckung des Grundkörpers
- P: Primärrichtung
- S: Sekundärrichtung
- T: Teilabschnitt
- U: Umlenkbereich

## Patentansprüche

1. Kühlvorrichtung (1) zum Kühlen einer Laserdiode, umfassend:
- ein Grundkörper (2) mit einer Außenseite (20) und mindestens einem integrierten Kühlkanal (5), insbesondere Mikrokühlkanal,
- eine Anbindungsfläche (21) an der Außenseite (20) des Grundkörpers (2) zur Anbindung des elektrischen Bauteils (4) an den Grundkörper (2) und
- eine erste Stabilisierungsschicht (11),
wobei die erste Stabilisierungsschicht (11) und die Anbindungsfläche (21) entlang einer Primärrichtung (P) übereinander angeordnet sind, und
wobei die erste Stabilisierungsschicht (11) gegenüber der Anbindungsfläche um einen Abstand (A) entlang einer parallel zur Primärrichtung (P) verlaufenden Richtung ins Innere des Grundkörpers (2) versetzt ist.

2. Kühlvorrichtung (1) gemäß Anspruch 1, wobei eine zweite Stabilisierungsschicht (12) vorgesehen ist, wobei die erste Stabilisierungsschicht (11), die zweite Stabilisierungsschicht (12) und die Anbindungsfläche (21) entlang einer Primärrichtung (P) übereinander angeordnet sind und wobei die erste Stabilisierungsschicht (11) näher an der Anbindungsfläche (21) als die zweite Stabilisierungsschicht (12) angeordnet ist.

3. Kühlvorrichtung (1) gemäß Anspruch 1 oder 2, wobei der Abstand (A) zwischen der Anbindungsfläche (21) und der ersten Stabilisierungsschicht (11) einen Wert zwischen 100 µm und 1000 µm, bevorzugt zwischen 150 µm und 750 µm und besonders bevorzugt zwischen 200 µm und 500 µm annimmt.

4. Kühlvorrichtung (1) gemäß einem der vorhergehenden Ansprüche, wobei die erste Stabilisierungsschicht (11) Diamant umfasst.

5. Kühlvorrichtung (1) gemäß einem der vorhergehenden Ansprüche, wobei die erste Stabilisierungsschicht Siliziumkarbid umfasst.

6. Kühlvorrichtung (1) gemäß einem der vorhergehenden Ansprüche, wobei die erste Stabilisierungsschicht (11) und die Anbindungsfläche (21) in Primärrichtung (P) gesehen deckungsgleich zueinander angeordnet sind.

7. Kühlvorrichtung (1) gemäß einem der vorhergehenden Ansprüche, wobei sich die erste Stabilisierungsschicht (11) entlang einer senkrecht zur Primärrichtung (P) verlaufenden Sekundärrichtung (S) über eine erste Länge (L1) erstreckt, wobei sich die zweite Stabilisierungsschicht (12) entlang der Sekundärrichtung (S) über eine zweite Länge (L2) erstreckt und die Anbindungsfläche (21) sich entlang der Sekundärrichtung (S) über eine dritte Länge (L3) erstreckt, wobei das Verhältnis der ersten Länge (L1) und/oder der zweiten Länge (L2) zur dritten Länge (L3) einen Wert zwischen 0,5 und 6,0 annimmt, vorzugsweise einen Wert zwischen 0,5 und 3,0, bevorzugt einen Wert zwischen 0,9 und 2,0 und besonders bevorzugt zwischen 0,95 und 1,5 annimmt.

8. Kühlvorrichtung (1) gemäß einem der vorhergehenden Ansprüche, wobei die erste Länge (L1) und/oder die zweite Länge (L2) einen Wert zwischen 5 und 25 mm bevorzugt zwischen 6 und 18 mm und besonders bevorzugt zwischen 7 und 15 mm annimmt.

9. Kühlvorrichtung gemäß einem der vorhergehenden Ansprüche, wobei sich die erste Stabilisierungsschicht (11) und/oder die zweite Stabilisierungsschicht (12) nicht über die gesamte Längserstreckung der Kühlvorrichtung (1) entlang der Sekundärrichtung (S) erstreckt.

10. Kühlvorrichtung (1) gemäß einem der vorhergehenden Ansprüche, wobei ein Verhältnis zwischen einer entlang der Sekundärrichtung (S) bemessenen dritten Länge (L3) der Anbindungsfläche (21) zu der ersten Länge (L1) der ersten Stabilisierungsschicht (11) einen Wert zwischen 0,33 und 0,99, bevorzugt zwischen 0,5 und 0,98 und besonders bevorzugt zwischen 0,66 und 0,95 annimmt.

11. Kühlvorrichtung (1) gemäß einem der vorhergehenden Ansprüche, wobei zwischen der ersten Stabilisierungsschicht (11) und der zweiten Stabilisierungsschicht (12) in Primärrichtung (P) gesehen ein Teilbereich (T) des Kühlkanals (5) verläuft.

12. Kühlvorrichtung (1) gemäß einem der vorhergehenden Ansprüche, wobei sich die erste Stabilisierungsschicht (11) von der zweiten Stabilisierungsschicht (12) unterscheidet, insbesondere in Hinblick auf die Position innerhalb des Grundkörpers (2), ihrer Materialzusammensetzung und/oder ihrer Dicke (D1, D2) in einer parallel zur Primärrichtung (P) verlaufenden Richtung.

13. Kühlvorrichtung (1) gemäß einem der vorhergehenden Ansprüche, wobei die erste Länge (L1) und/oder die dritte Länge (L3) größer ist als der in Primärrichtung (P) bemessene Abstand (A) zwischen der ersten Stabilisierungsschicht (11) und der Anbindungsfläche (21).

14. Verfahren zur Herstellung einer Kühlvorrichtung (1) gemäß einem der vorhergehenden Ansprüche, wobei die erste Stabilisierungsschicht (11) und/oder die zweite Stabilisierungsschicht (12) mittels eines AMB-Verfahrens an den Grundkörper (2) angebunden werden.

## Claims

1. A cooling device (1) for cooling a laser diode, comprising
- a base body (2) with an outer side (20) and at least one integrated cooling channel (5), in particular a microcooling channel,
- a bonding surface (21) on the outer side (20) of the base body (2) for connecting the electrical components (4) to the base body (2) and
- a first stabilizing layer (11),
wherein the first stabilizing layer (11) and the bonding surface (21) are arranged on top of one another along a primary direction (P), and
wherein the first stabilizing layer (11) is offset from the bonding surface by a distance (A) along a direction parallel to the primary direction (P) into an interior of the base body (2).

2. The cooling device (1) according to claim 1, wherein a second stabilizing layer (12) is provided, wherein the first stabilizing layer (11), the second stabilizing layer (12) and the bonding surface (21) are arranged on top of one another along a primary direction (P) and wherein the first stabilizing layer (11) is arranged closer to the bonding surface (21) than the second stabilizing layer (12).

3. The cooling device (1) according to claim 1 or 2, wherein the distance (A) between the bonding surface (21) and the first stabilizing layer (11) has a value of between 100 µm and 1000 µm, preferably between 150 µm and 750 µm, and most preferably between 200 µm and 500 µm.

4. The cooling device (1) according to any one of the preceding claims, wherein the first stabilizing layer (11) comprises diamond.

5. The cooling device (1) according to any one of the preceding claims, wherein the first stabilizing layer comprises silicon carbide.

6. The cooling device (1) according to one of the preceding claims, wherein the first stabilizing layer (11) and the bonding surface (21) are arranged congruently to each other as seen in the primary direction (P).

7. The cooling device (1) according to one of the preceding claims, wherein the first stabilizing layer (11) extends along a secondary direction (S) running perpendicular to the primary direction (P) over a first length (L1), wherein the second stabilizing layer (12) extends along the secondary direction (S) over a second length (L2) and the bonding surface (21) extends along the secondary direction (S) across a third length (L3), wherein the ratio of the first length (L1) and/or the second length (L2) to the third length (L3) has a value between 0.5 and 6.0, preferably a value between 0.5 and 3.0, more preferably a value between 0.9 and 2.0, and most preferably between 0.95 and 1.5.

8. The cooling device (1) according to one of the preceding claims, wherein the first length (L1) and/or the second length (L2) has a value between 5 and 25 mm preferably between 6 and 18 mm and more preferably between 7 and 15 mm.

9. The cooling device according to one of the preceding claims, wherein the first stabilizing layer (11) and/or the second stabilizing layer (12) does not extend across the entire longitudinal extent of the cooling device (1) along the secondary direction (S).

10. The cooling device (1) according to one of the preceding claims, wherein a ratio between a third length (L3) of the bonding surface (21) measured along the secondary direction (S) to the first length (L1) of the first stabilizing layer (11) has a value between 0.33 and 0.99, preferably between 0.5 and 0.98 and more preferably between 0.66 and 0.95.

11. The cooling device (1) according to one of the preceding claims, wherein a subregion (T) of the cooling channel (5) extends between the first stabilizing layer (11) and the second stabilizing layer (12) as seen in the primary direction (P).

12. The cooling device (1) according to one of the preceding claims, wherein the first stabilizing layer (11) differs from the second stabilizing layer (12), in particular with regard to the position within the base body (2), its material composition and/or its thickness (D1, D2) in a direction running parallel to the primary direction (P).

13. The cooling device (1) according to one of the preceding claims, wherein the first length (L1) and/or the third length (L3) is greater than the distance (A), measured in the primary direction (P), between the first stabilizing layer (11) and the bonding surface (21).

14. A method for the production of a cooling device (1) according to one of the preceding claims, wherein the first stabilizing layer (11) and/or the second stabilizing layer (12) are bonded to the base body (2) by means of an AMB process.

## Revendications

1. Dispositif de refroidissement (1) pour refroidir une diode laser (4), comprenant
- un corps de base (2) ayant une face extérieure (20) et au moins un canal de refroidissement intégré (5), en particulier un micro-canal de refroidissement,
- une surface de liaison (21) sur la face extérieure (20) du corps de base (2) pour relier le composant électrique (4) au corps de base (2), et
- une première couche de stabilisation (11),
dans lequel
la première couche de stabilisation (11) et la surface de liaison (21) sont disposées l'une au-dessus de l'autre le long d'une direction primaire (P), et
la première couche de stabilisation (11) est décalée par rapport à la surface de liaison d'une distance (A) le long d'une direction parallèle à la direction primaire (P), vers l'intérieur du corps de base (2).

2. Dispositif de refroidissement (1) selon la revendication 1,
dans lequel il est prévu une deuxième couche de stabilisation (12),
la première couche de stabilisation (11), la deuxième couche de stabilisation (12) et la surface de liaison (21) sont disposées les unes au-dessus des autres le long d'une direction primaire (P), et
la première couche de stabilisation (11) est disposée plus près de la surface de liaison (21) que la deuxième couche de stabilisation (12).

3. Dispositif de refroidissement (1) selon la revendication 1 ou 2,
dans lequel la distance (A) entre la surface de liaison (21) et la première couche de stabilisation (11) prend une valeur comprise entre 100 µm et 1000 µm, de préférence entre 150 µm et 750 µm, et de manière particulièrement préférée entre 200 µm et 500 µm.

4. Dispositif de refroidissement (1) selon l'une des revendications précédentes, dans lequel la première couche de stabilisation (11) contient du diamant.

5. Dispositif de refroidissement (1) selon l'une des revendications précédentes, dans lequel la première couche de stabilisation contient du carbure de silicium.

6. Dispositif de refroidissement (1) selon l'une des revendications précédentes, dans lequel la première couche de stabilisation (11) et la surface de liaison (21) sont disposées de manière à coïncider l'une avec l'autre, vues dans la direction primaire (P).

7. Dispositif de refroidissement (1) selon l'une des revendications précédentes, dans lequel la première couche de stabilisation (11) s'étend sur une première longueur (L1) le long d'une direction secondaire (S) perpendiculaire à la direction primaire (P),
la deuxième couche de stabilisation (12) s'étend sur une deuxième longueur (L2) le long de la direction secondaire (S), et
la surface de liaison (21) s'étend sur une troisième longueur (L3) le long de la direction secondaire (S),
le rapport de la première longueur (L1) et/ou de la deuxième longueur (L2) sur la troisième longueur (L3) prend une valeur comprise entre 0,5 et 6,0, de préférence une valeur comprise entre 0,5 et 3,0, de préférence une valeur comprise entre 0,9 et 2,0, et de manière particulièrement préférée entre 0,95 et 1,5.

8. Dispositif de refroidissement (1) selon l'une des revendications précédentes, dans lequel la première longueur (L1) et/ou la deuxième longueur (L2) prend une valeur comprise entre 5 et 25 mm, de préférence entre 6 et 18 mm, et de manière particulièrement préférée entre 7 et 15 mm.

9. Dispositif de refroidissement selon l'une des revendications précédentes, dans lequel la première couche de stabilisation (11) et/ou la deuxième couche de stabilisation (12) ne s'étend pas sur toute l'extension longitudinale du dispositif de refroidissement (1) le long de la direction secondaire (S).

10. Dispositif de refroidissement (1) selon l'une des revendications précédentes, dans lequel le rapport entre une troisième longueur (L3) de la surface de liaison (21), dimensionnée selon la direction secondaire (S), et la première longueur (L1) de la première couche de stabilisation (11) prend une valeur comprise entre 0,33 et 0,99, de préférence entre 0,5 et 0,98 et de manière particulièrement préférée entre 0,66 et 0,95.

11. Dispositif de refroidissement (1) selon l'une des revendications précédentes, dans lequel une zone partielle (T) du canal de refroidissement (5) s'étend entre la première couche de stabilisation (11) et la deuxième couche de stabilisation (12), vue dans la direction primaire (P).

12. Dispositif de refroidissement (1) selon l'une des revendications précédentes, dans lequel la première couche de stabilisation (11) diffère de la deuxième couche de stabilisation (12), en particulier en ce qui concerne sa position à l'intérieur du corps de base (2), sa composition de matériaux et/ou son épaisseur (D1, D2) dans une direction parallèle à la direction primaire (P).

13. Dispositif de refroidissement (1) selon l'une des revendications précédentes, dans lequel la première longueur (L1) et/ou la troisième longueur (L3) est supérieure à la distance (A), dimensionnée dans la direction primaire (P), entre la première couche de stabilisation (11) et la surface de liaison (21).

14. Procédé de fabrication d'un dispositif de refroidissement (1) selon l'une des revendications précédentes,
dans lequel la première couche de stabilisation (11) et/ou la deuxième couche de stabilisation (12) sont reliées au corps de base (2) au moyen d'un procédé AMB (brasage de métal actif).
